# EUROPEAN PATENT APPLICATION

(11) **EP 3 819 353 A1**
(43) Date of publication of application: **12.05.2021**
(21) Application number: 19830542.7
(22) Date of filing: 01.07.2019
(51) Int. Cl.: C09K 3/14, B24B 37/00, H01L 21/304

(54) **POLISHING COMPOSITION**

(30) Priority: 04.07.2018 JP 2018127240
(71) Applicant: Sumitomo Seika Chemicals Co., Ltd., Kako-gun, Hyogo 675-0145 (JP)
(72) Inventor: MASUDA, Tsuyoshi, Himeji-shi, Hyogo 672-8076 (JP); NISHIGUCHI, Hideaki, Kako-gun, Hyogo 675-0145 (JP)
(74) Representative: Vossius & Partner Patentanwälte Rechtsanwälte mbB
(86) International application number: PCT/JP2019/026041
(87) International publication number: WO 2020/009055

(57) **Abstract**

Provided is a polishing means that can improve the flatness of a substrate without significantly reducing the polishing speed. More specifically, provided is a polishing composition comprising inorganic particles, water, and a water-soluble polymer, wherein (i) a 1 mass (wt/wt)% aqueous solution of the water-soluble polymer has a normal stress (N) of 1 or more at a shear rate of 10000 (1/S), or (ii) a 0.25 mass (wt/wt)% aqueous solution of the water-soluble polymer has a normal stress (N) of 1 or more at a shear rate of 10000 (1/S).

## Description

### Technical Field

The present disclosure relates to a polishing composition and the like.

### Background Art

In the mirror processing of semiconductor wafers etc. used as base materials for forming integrated circuits, chemical mechanical polishing (hereinafter also referred to as "CMP") is generally used. This is a method of having a polishing slurry containing silica-based or ceria-based inorganic abrasive grains flow between a polishing cloth or a polishing pad and an object to be polished, such as a semiconductor wafer, and chemically and mechanically polishing the object.

Polishing by CMP requires surface smoothing, high polishing speed, and the like. In particular, with the miniaturization of semiconductor devices or the higher integration of integrated circuits, higher levels of reduction in surface defects and flatness are required for substrates, such as semiconductor wafers.

In order to reduce surface defects and achieve higher flatness, it has been proposed to polish the substrate surface with a polishing composition containing a water-soluble polymer. For example, proposals have been made for a polishing composition comprising a water-soluble polymer having a molecular weight of 100,000 or more (PTL 1), and a polishing composition comprising a cellulose derivative or polyvinyl alcohol (PTL 2). However, in order to improve the flatness of the substrate, it is necessary to reduce the polishing speed, which has caused the problem of polishing efficiency dropping.

### Citation List

### Patent Literature

PTL 1: JPH02-158684A
PTL 2: JPH11-116942A

### Summary of Invention

### Technical Problem

The present inventors intended to provide a polishing composition that can improve the flatness of a substrate without significantly reducing the polishing speed, by using a specific polymer for polishing.

### Solution to Problem

The present inventors found the possibility that the surface roughness of a substrate could be preferably reduced by polishing the substrate using a composition comprising inorganic particles, water, and a specific water-soluble polymer, and made further improvements.

The present disclosure includes, for example, the subjects described in the following items.
Item 1. A polishing composition (preferably a polishing composition for a substrate forming an integrated circuit) comprising inorganic particles, water, and a water-soluble polymer,
   wherein a 1 mass (wt/wt)% aqueous solution of the water-soluble polymer has a normal stress (N) of 1 or more at a shear rate of 10000 (1/S).
Item 2. A polishing composition (preferably a polishing composition for a substrate forming an integrated circuit) comprising inorganic particles, water, and a water-soluble polymer,
   wherein a 0.25 mass (wt/wt)% aqueous solution of the water-soluble polymer has a normal stress (N) of 1 or more at a shear rate of 10000 (1/S).
Item 3. The polishing composition comprising inorganic particles, water, and a water-soluble polymer according to Item 1,
   wherein the water-soluble polymer is hydroxyethyl cellulose, polyethylene oxide, or a combination thereof, a 1 mass (wt/wt)% aqueous solution of which has a normal stress (N) of 1 or more at a shear rate of 10000 (1/S).
Item 4. The polishing composition comprising inorganic particles, water, and a water-soluble polymer according to Item 2,
   wherein the water-soluble polymer is hydroxyethyl cellulose, polyethylene oxide, or a combination thereof, a 0.25 mass (wt/wt)% aqueous solution of which has a normal stress (N) of 1 or more at a shear rate of 10000 (1/S).

### Advantageous Effects of Invention

A polishing means that can improve the flatness of a substrate without significantly reducing the polishing speed is provided.

### Brief Description of Drawing

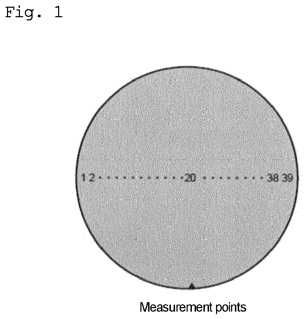

Fig. 1 shows measurement points (39 points) for measuring the amount of polishing, polishing speed, and flatness when a substrate is polished.

### Description of Embodiments

Embodiments included in the present disclosure will be described in more detail below. The present disclosure preferably includes a polishing composition, a method for producing the same, and the like, but is not limited thereto. The present disclosure includes everything disclosed in the present specification and recognizable to those skilled in the art.

The polishing composition included in the present disclosure comprises inorganic particles, water, and a specific water-soluble polymer. Hereinafter, this polishing composition is also referred to as "the polishing composition of the present disclosure."

The specific water-soluble polymer is a water-soluble polymer, a 1 mass (wt/wt)% aqueous solution of which has a normal stress of 1 or more at a shear rate of 10000 (1/S) (hereinafter, this water-soluble polymer is also referred to as "water-soluble polymer (i)"). Further, the water-soluble polymer may be a water-soluble polymer, a 0.25 mass (wt/wt)% aqueous solution of which has a normal stress of 1 or more at a shear rate of 10000 (1/S) (hereinafter, this water-soluble polymer is also referred to as "water-soluble polymer (ii)"). In addition, water-soluble polymers (i) and (ii) are also collectively referred to as "the water-soluble polymer of the present disclosure."

The water-soluble polymer of the present disclosure is a water-soluble polymer, an aqueous solution of which with a specific concentration has a normal stress of 1 or more at a shear rate of 10000 (1/S). The specific concentration of water-soluble polymer (i) is 1 mass (wt/wt)%, and the specific concentration of water-soluble polymer (ii) is 0.25 mass (wt/wt)%. In the present specification, mass% indicates (wt/wt)%, unless otherwise specified. Further, the normal stress at a shear rate of 10000 (1/S) is measured in a water-soluble polymer aqueous solution with the above concentration using a rheometer (the steady viscosity at a shear rate of 0.01 to 10000 (1/s) being measured under the conditions of a 40-mm-diameter parallel plate, a gap of 100 pm, and 25°C).

A 1 mass% aqueous solution of water-soluble polymer (i) has a normal stress (N) at a shear rate of 10000 (1/S) of preferably about 1 to 5000, and more preferably about 20 to 4000. The lower limit of this range may be, for example, about 30, 40, 50, 60, 70, 80, 90, 100, 110, 120, 130, 140, 150, 160, 170, 180, 190, 200, 210, 220, 230, 240, or 250. Further, the upper limit of this range may be, for example, about 3500, 3000, 2500, 2000, 1500, or 1000.

A 0.25 mass% aqueous solution of water-soluble polymer (ii) has a normal stress (N) at a shear rate of 10000 (1/S) of preferably about 1 to 8000, and more preferably about 1000 to 7000. The lower limit of this range may be, for example, about 1500, 2000, 2500, 3000, 3500, or 4000. Further, the upper limit of this range may be, for example, about 6500 or 6000.

More specifically, water-soluble polymer (i) is preferably, for example, hydroxyethyl cellulose, polyethylene oxide, or a combination thereof, a 1 mass (wt/wt)% aqueous solution of which has a normal stress (N) of 1 or more at a shear rate of 10000 (1/S). This water-soluble polymer is also referred to as "water-soluble polymer (ia)."

Further, more specifically, water-soluble polymer (ii) is preferably, for example, hydroxyethyl cellulose, polyethylene oxide, or a combination thereof, a 0.25 mass (wt/wt)% aqueous solution of which has a normal stress (N) of 1 or more at a shear rate of 10000 (1/S). This water-soluble polymer is also referred to as "water-soluble polymer (iia)."

Examples of hydroxyethyl cellulose corresponding to water-soluble polymer (ia) include CF-V, CF-W, CF-X, and CF-Y (all of which are produced by Sumitomo Seika Chemicals Co., Ltd.), Natrosol series (produced by Ashland; e.g., Natrosol 250), Cellosize QP series, WP series, ER series (produced by Dow), Tylose series (produced by Shin-Etsu Chemical Co., Ltd.; e.g., H6000YP2 and H4000P2), SE600 (produced by Daicel FineChem Ltd.), and the like. Moreover, examples of polyethylene oxide corresponding to water-soluble polymer (ia) include PEO-8 (produced by Sumitomo Seika Chemicals Co., Ltd.) and the like. When a combination of hydroxyethyl cellulose and polyethylene oxide is used, there is no particular limitation as long as the combination corresponds to water-soluble polymer (ia). Examples include a combination of the above hydroxyethyl cellulose corresponding to water-soluble polymer (ia) and the above polyethylene oxide corresponding to water-soluble polymer (ia). The ratio in this combination is a mass ratio (hydroxyethyl cellulose:polyethylene oxide), and is preferably about 1:9 to 9:1 or 2:8 to 8:2, for example.

Examples of polyethylene oxide corresponding to water-soluble polymer (iia) include PEO series (produced by Sumitomo Seika Chemicals Co., Ltd.; e.g., PEO-1, 2, 3, 4, 8, 15, 18, 27, and 29), Ucarfloc series (produced by Dow), Polyox series (produced by Dow), Alkox series (Meisei Chemical Works, Ltd.), and the like. When a combination of hydroxyethyl cellulose and polyethylene oxide is used, there is no particular limitation as long as the combination corresponds to water-soluble polymer (iia). The ratio in this combination is a mass ratio (hydroxyethyl cellulose:polyethylene oxide), and is preferably about 1:9 to 9:1 or 2:8 to 8:2, for example.

In the polishing composition of the present disclosure, water-soluble polymer (i) is preferably contained in an amount of, for example, about 0.001 to 1 mass%, more preferably about 0.005 to 0.75 mass%, and even more preferably about 0.01 to 0.5 mass%. Further, in the polishing composition of the present disclosure, water-soluble polymer (ii) is preferably contained in an amount of, for example, about 0.001 to 0.5 mass%, more preferably about 0.005 to 0.3 mass%, even more preferably about 0.01 to 0.1 mass%, and still even more preferably about 0.02 to 0.05 mass%.

As the inorganic particles, those known as inorganic abrasive grains for polishing can be preferably used. Specific examples include transition metal oxides, aluminum oxide, silica, titanium oxide, silicon carbide, diamond, and the like. In particular, silica and transition metal oxides are preferable. More specifically, the silica is preferably, for example, colloidal silica, fumed silica, precipitated silica, or the like. The transition metal is preferably cerium oxide, zirconium oxide, iron oxide, or the like; and particularly preferably cerium oxide. The inorganic particles can be used singly or in combination of two or more.

The average particle size of these inorganic particles is preferably 2 µm or less, and more preferably 1.5 µm or less, 1 µm or less, 0.5 µm or less, 0.3 µm or less, 0.2 µm, or 0.1 µm or less. The average particle size of the inorganic particles is the particle size at an integrated value of 50% in the particle size distribution measured by a laser diffraction scattering method using water as a solvent.

Although it is not particularly limited, the polishing composition of the present disclosure is preferably in the form of a slurry (in the present specification, the polishing composition in the form of a slurry is also particularly referred to as a "polishing slurry"). The polishing composition (particularly polishing slurry) of the present disclosure can be prepared, for example, by mixing inorganic particles, water, and water-soluble polymer (i) or (ii).

In the polishing composition of the present disclosure, the content mass ratio of water-soluble polymer (i) or (ii) and inorganic particles (water-soluble polymer:inorganic particles) is not particularly limited as long as the effect is exhibited, but is, for example, preferably about 1:50 to 5000, and more preferably about 1:100 to 4000, about 1:150 to 3500, about 1:200 to 3000, or about 1:250 to 2500. Further, the lower limit of this range may be, for example, about 500, 1000, 1500, or 2000.

To the extent that the effect is not impaired, the polishing composition of the present disclosure may further contain various additives known in the art. Examples of such known additives include surfactants, organic polyanionic substances, chelating agents, pH regulators, and the like. Examples of surfactants include sodium alkylbenzene sulfonate, formalin condensates of naphthalene sulfonic acid, and the like. Examples of organic polyanionic substances include lignin sulfonate, polyacrylate, and the like. Examples of chelating agents include dimethylglyoxime, dithizone, oxine, acetylacetone, glycine, EDTA, NTA, and the like. Examples of pH regulators include bases and acids. Examples of bases include sodium hydroxide, potassium hydroxide, ammonium hydroxide, tetramethylammonium hydroxide (TMAH), ammonia, choline compounds (e.g., choline hydroxide), and the like. Examples of acids include hydrochloric acid, sulfuric acid, phosphoric acid, nitric acid, and the like. Of these, potassium hydroxide is preferable as the base, and sulfuric acid is preferable as the acid. Such known additives can be used singly or in combination of two or more.

The polishing composition of the present disclosure can be preferably used, for example, for polishing the surface of a substrate for forming an integrated circuit (e.g., a semiconductor wafer such as a silicon wafer; the wafer may have an oxide film), and the surface roughness of the substrate can be further reduced.

In the present specification, the term "comprising" includes "consisting essentially of" and "consisting of." Further, the present disclosure includes all of any combinations of the constituent requirements described in the present specification.

In addition, the various characteristics (properties, structures, functions, etc.) described in each embodiment of the present disclosure described above may be combined in any way in specifying the subjects included in the present disclosure. In other words, the present disclosure includes all the subjects comprising all combinations of the combinable characteristics described in the present specification.

### Examples

The subjects of the present disclosure will be described in more detail below; however, the subjects of the present disclosure are not limited to the following examples.

### Polishing property evaluation method

A polishing pad (IC1400 K-XY Grv, produced by Nitta Haas Inc.) was set in a polishing apparatus (RDP-500, produced by Fujikoshi Machinery Corp.). Using a diamond dresser (#100, produced by Asahi Diamond Industrial Co., Ltd.), the polishing pad surface was ground at 8.5 kgf and a dresser rotation speed of 100 rotations/minute for 10 minutes. Next, while the polishing slurry produced in each of the Examples or Comparative Examples was supplied at a speed of 150 ml/min under the conditions of a platen rotation speed of 90 rpm, a head rotation speed of 90 rpm, a polishing pressure of 280 g/cm², and a polishing time of 60 seconds, a silicon wafer having an oxide film surface (1000 nm) with a diameter of 8 inches was polished.

The polishing properties of each polishing slurry were evaluated by evaluating the polishing speed during polishing and the surface roughness of the silicon wafer surface after polishing. The polishing speed and surface roughness were evaluated by the following methods.

### Polishing speed

The film thickness of the oxide film on the silicon wafer surface before and after polishing was measured with a noncontact optical film thickness meter (Nanospec 5100, produced by Nanometrics) to determine the amount of polishing. The amount of polishing was measured at 39 points (see Fig. 1) on the silicon wafer, and their average value was used as the polishing speed. The standard deviation of the measurement results was regarded as the flatness.

### Surface roughness

The surface roughness of the oxide film on the silicon wafer surface 20 (the center point of polishing amount measurement points 1 to 39) before and after polishing was measured by AFM (AFM5400L, produced by Hitachi High-Tech Science Corporation).

### Normal stress of water-soluble polymer

According to the formulations in Table 1, a water-soluble polymer was selected from hydroxyethyl cellulose (HEC), polyethylene oxide (PEO), a combination thereof, or carboxymethyl cellulose (CMC), and a 1 mass (wt/wt)% aqueous solution or 0.25 mass (wt/wt)% aqueous solution of the water-soluble polymer was prepared. The preparation was carried out by adding each water-soluble polymer to water, and stirring the resulting mixture with a jar tester for 8 hours. Then, the steady viscosity of each water-soluble polymer aqueous solution was measured using a rheometer (AR-2000EX, produced by TA) at a shear rate of 0.01 to 10000 (1/s) under the conditions of a 40-mm-diameter parallel plate, a gap of 100 µm, and 25°C, and the normal stress was measured. Table 1 also shows the normal stress (N) at a shear rate of 10000 (1/s).

**Table 1**

| Experiment No. | Polymer | Product number | Concentration (wt/wt%) | Shear rate 10000 (1/s) |
|---|---|---|---|---|
| | | | | Normal stress (N) |
| 1 | HEC | CF-V | 1 | 307 |
| 2 | HEC | CF-W | 1 | 296 |
| 3 | HEC | CF-X | 1 | 470 |
| 4 | HEC | CF-Y | 1 | 545 |
| 5 | PEO | PEO-8 | 1 | 3362 |
| 6 | PEO | PEO-29 | 0.25 | 5666 |
| 7 | HEC | Natrosol 250 | 1 | 307 |
| 8 | HEC | SE600 | 1 | 114 |
| 9 | HEC/PEO | CF-V/PEO-8 | 0.75/0.25 | 1990 |
| 10 | CMC | Cellogen F-AG | 1 | 0 |

CF-V, CF-W, CF-X, and CF-Y are HECs produced by Sumitomo Seika Chemicals Co., Ltd. A 2 mass% aqueous solution of CF-V has a viscosity of about 5000 to 10000 (mPa·s) when measured with a B-type viscometer (Rotor No. 3, rotation speed: 12 rpm). A 2 mass% aqueous solution of CF-W has a viscosity of about 10000 to 16000 (mPa·s) when measured with a B-type viscometer (Rotor No. 4, rotation speed: 12 rpm). A 1 mass% aqueous solution of CF-X has a viscosity of about 1250 to 1750 (mPa·s) when measured with a B-type viscometer (Rotor No. 3, rotation speed: 30 rpm). A 1 mass% aqueous solution of CF-Y has a viscosity of about 2000 to 3000 (mPa·s) when measured with a B-type viscometer (Rotor No. 3, rotation speed: 30 rpm). Natrosol 250 is HEC produced by Ashland. SE600 is HEC produced by Daicel FineChem Ltd., a 2% aqueous solution of which has a viscosity of about 4800 to 6000 (mP·as).

Further, PEO-8 and PEO-29 are PEOs produced by Sumitomo Seika Chemicals Co., Ltd. A 0.5 mass% aqueous solution of PEO-8 has a viscosity of about 20 to 70 (mPa·s) when measured with a B-type viscometer (Rotor No. 1, rotation speed: 12 rpm). A 0.5 mass% aqueous solution of PEO-29 has a viscosity of about 800 to 1000 (mPa·s) when measured with a B-type viscometer (Rotor No. 2, rotation speed: 12 rpm).

In addition, Cellogen F-AG is CMC produced by DKS Co. Ltd., a 2 mass% aqueous solution of which has a viscosity of about 900 to 1500 (mPa·s).

### Examples 1 to 9 and Comparative Example 1

Polymer aqueous solutions were prepared using the water-soluble polymers used in Experiment Nos. 1 to 10 in Table 1. Then, 25 mass% (1 kg) of Slurry SS25 produced by Cabot Corporation (fumed silica (average particle size: 0.16 pm)) and each of the prepared polymer aqueous solutions (1 kg) were mixed to obtain polishing slurries (slurries 1 to 10). The polishing properties were evaluated for these slurries 1 to 10. Table 2 shows the results. Table 2 also shows the concentration of the polymer contained in each slurry.

### Comparative Example 2

Slurry SS25 produced by Cabot Corporation (1 kg) was diluted with distilled water to a total weight of 2 kg to obtain a polishing slurry (slurry 11). The polishing properties were evaluated using this slurry 11 by the above method. Table 2 shows the results.

**Table 2**

| Examples and Comparative Examples | Water-soluble polymer (Table 1) | Slurry | Water-soluble polymer content of slurry (wt/wt%) | Polishing speed (nm/min) | Flatness | Surface roughness Ra (nm) |
|---|---|---|---|---|---|---|
| Example 1 | Experiment No.1 | 1 | 0.05 | 180 | 34 | 0.192 |
| Example 2 | Experiment No.2 | 2 | 0.1 | 178 | 26 | 0.221 |
| Example 3 | Experiment No.3 | 3 | 0.1 | 170 | 31 | 0.197 |
| Example 4 | Experiment No.4 | 4 | 0.1 | 153 | 27 | 0.220 |
| Example 5 | Experiment No.5 | 5 | 0.025 | 205 | 32 | 0.174 |
| Example 6 | Experiment No.6 | 6 | 0.025 | 182 | 24 | 0.198 |
| Example 7 | Experiment No.7 | 7 | 0.3 | 156 | 26 | 0.222 |
| Example 8 | Experiment No.8 | 8 | 0.5 | 129 | 23 | 0.234 |
| Example 9 | Experiment No.9 | 9 | 0.1 | 186 | 30 | 0.189 |
| Comparative Example 1 | Experiment No.10 | 10 | 0.3 | 227 | 49 | 0.177 |
| Comparative Example 2 | - | 11 | - | 241 | 36 | 0.175 |

| | | | | | | |
|---|---|---|---|---|---|---|
| "Ra" indicates the arithmetic average roughness. | | | | | | |

## Claims

1. A polishing composition comprising inorganic particles, water, and a water-soluble polymer,
wherein a 1 mass (wt/wt)% aqueous solution of the water-soluble polymer has a normal stress (N) of 1 or more at a shear rate of 10000 (1/S).

2. A polishing composition comprising inorganic particles, water, and a water-soluble polymer,
wherein a 0.25 mass (wt/wt)% aqueous solution of the water-soluble polymer has a normal stress (N) of 1 or more at a shear rate of 10000 (1/S).

3. The polishing composition comprising inorganic particles, water, and a water-soluble polymer according to claim 1,
wherein the water-soluble polymer is hydroxyethyl cellulose, polyethylene oxide, or a combination thereof, a 1 mass (wt/wt)% aqueous solution of which has a normal stress (N) of 1 or more at a shear rate of 10000 (1/S).

4. The polishing composition comprising inorganic particles, water, and a water-soluble polymer according to claim 2,
wherein the water-soluble polymer is hydroxyethyl cellulose, polyethylene oxide, or a combination thereof, a 0.25 mass (wt/wt)% aqueous solution of which has a normal stress (N) of 1 or more at a shear rate of 10000 (1/S).
